# EUROPEAN PATENT APPLICATION

(11) **EP 4 629 492 A1**
(43) Date of publication of application: **08.10.2025**
(21) Application number: 25162550.5
(22) Date of filing: 10.03.2025
(51) Int. Cl.: H02M 1/00, H02M 7/00, G01R 15/18, G01R 19/00, H02J 3/38, H02S 40/32

(54) **BACKUP POWER DEVICE AND PHOTOVOLTAIC SYSTEM**

(30) Priority: 11.03.2024 CN 202410272503
(71) Applicant: Huawei Digital Power Technologies Co., Ltd., Shenzhen, Guangdong 518043 (CN)
(72) Inventor: YANG, Hua, Shenzhen, 518043 (CN); LI, Jia, Shenzhen, 518043 (CN); ZHANG, Zhanjing, Shenzhen, 518043 (CN); HE, Yuan, Shenzhen, 518043 (CN)
(74) Representative: Gill Jennings & Every LLP

(57) **Abstract**

This application relates to the field of energy technologies, and provides a backup power device and a photovoltaic system, to resolve problems such as high costs and a large occupied board area of a power board assembly in the backup power device. The backup power device provided in this application includes a power board and a regulation board. The regulation board is perpendicularly disposed on a surface of the power board. The power board includes a conductive wire and a switching component. The regulation board includes a semi-closed Rogowski coil and a regulation circuit. The semi-closed Rogowski coil crosses the conductive wire, and is configured to: induce a current in the conductive wire and generate an induction signal. The regulation circuit is configured to performing operation processing on the induction signal for output. The power board assembly further includes a controller, where the controller is connected to the regulation circuit and the switching component, and is configured to control on or off of the switching component based on an output signal of the regulation circuit. In the backup power device provided in this application, the semi-closed Rogowski coil has an advantage of low costs, which is conducive to wide application. The regulation board and the power board are perpendicularly disposed, occupying a small board area.

## Description

### TECHNICAL FIELD

This application relates to the field of energy technologies, and in particular, to a backup power device and a photovoltaic system.

### BACKGROUND

With continuous development of new energy technologies, a power board assembly used to implement power conversion is widely used in a plurality of different types of devices. For example, a photovoltaic system mainly includes a photovoltaic power generation device and a backup power device. The photovoltaic power generation device is configured to convert solar energy into a direct current, and the backup power device is connected between the photovoltaic power generation device and a power grid. The backup power device includes a power board assembly, and the backup power device is configured to convert, via the power board assembly, the direct current generated by the photovoltaic power generation device into an alternating current, and then transmit the alternating current to the power grid. During actual application, a current in the backup power device needs to be effectively detected, to ensure safety of the backup power device. In an existing backup power device, a sampling resistor or a current transformer is usually used to effectively detect the current. However, the foregoing two solutions have problems such as a large quantity of used components, a large occupied board area, and high costs. Therefore, it is difficult to widely apply the two solutions.

### SUMMARY

This application provides a cost-effective backup power device that has a good current detection function and occupies a small board area, and a photovoltaic system.

According to a first aspect, this application provides a backup power device, including a power board and a regulation board, where the regulation board is disposed on a surface of the power board, and the regulation board is perpendicular to the power board; the power board includes a conductive wire and a switching component, and the switching component is connected to the conductive wire in series; the regulation board includes a semi-closed Rogowski coil and a regulation circuit, and the regulation circuit is connected to the semi-closed Rogowski coil; the semi-closed Rogowski coil crosses the conductive wire, and is configured to: induce a current in the conductive wire and generate an induction signal, and the regulation circuit is configured to generate a detection signal after performing operation processing on the induction signal; and the backup power device further includes a controller, where the controller is disposed on the power board or the regulation board, is connected to the regulation circuit and the switching component, and is configured to control on or off of the switching component based on the detection signal of the regulation circuit. In the backup power device provided in this application, the semi-closed Rogowski coil has an advantage of low costs, which is conducive to wide application. The semi-closed Rogowski coil is used, so that the regulation board can be perpendicularly disposed on a side of the power board, and a good current detection function is implemented. In addition, the regulation board occupies a small board area in the power board, which helps implement a miniaturization design of the backup power device, so that the backup power device can be better used in a device having a high requirement on space.

It should be noted that, the controller being configured to control on or off of the switching component based on the detection signal of the regulation circuit specifically means that the controller further needs to refer to the detection signal when switching an on state or an off state of the switching component based on a control signal. Alternatively, it may be understood that, when the detection signal meets a condition, the controller may switch the on state or the off state of the switching component. When the detection signal does not meet the condition, the controller cannot switch the on state or the off state of the switching component.

For example, when the current in the conductive wire is less than a preset value, the regulation circuit generates a corresponding detection signal. In this case, the detection signal meets the condition, and the controller may switch the on state or the off state of the switching component.

Alternatively, when the current in the conductive wire is greater than or equal to the preset value, the regulation circuit generates a corresponding detection signal. In this case, the detection signal does not meet the condition, and the controller cannot switch the on state or the off state of the switching component.

Alternatively, it may be understood that, in some cases, the switching component does not have a turn-on/off capability under a large current; otherwise, a bad case like arcing may occur. Therefore, the switching component is allowed to switch between the on state and the off state only when the current in the conductive wire is small. Therefore, use safety of the switching component can be ensured.

During specific disposing, the semi-closed Rogowski coil may be in a semi-circular ring shape, and the conductive wire penetrates a center of the semi-closed Rogowski coil, so that the semi-closed Rogowski coil can effectively and accurately detect the current flowing through the conductive wire.

In an example, the regulation board includes a dielectric substrate, and the semi-closed Rogowski coil is located in the dielectric substrate. Alternatively, it may be understood that the semi-closed Rogowski coil may be packaged in the dielectric substrate, to ensure safety of the semi-closed Rogowski coil.

Alternatively, in an example, the semi-closed Rogowski coil is located on a side of the dielectric substrate. During preparing, the semi-closed Rogowski coil may be disposed on the side of the dielectric substrate through soldering or the like, facilitating preparation.

In an example, the semi-closed Rogowski coil is located between the regulation circuit and the conductive wire, so that the regulation circuit does not block between the semi-closed Rogowski coil and the conductive wire. In this way, detection effect of the semi-closed Rogowski coil is effectively ensured.

In an example, the semi-closed Rogowski coil includes a first end and a second end; and the semi-closed Rogowski coil is formed by a spiral wire, and both ends of the spiral wire are located at the first end or the second end. Alternatively, it may be understood that, signal output ends of the semi-closed Rogowski coil are all located at a same end of the semi-closed Rogowski coil, to effectively connect to the regulation circuit.

During specific disposing, in the semi-closed Rogowski coil, one end of the spiral wire is located at the first end, and the other end of the spiral wire extends from the second end along an axis of the semi-closed Rogowski coil to the first end; or one end of the spiral wire is located at the second end, and the other end of the spiral wire extends from the first end along the axis of the semi-closed Rogowski coil to the second end.

In an example, an edge of the regulation board includes a conductive protrusion, and the regulation circuit is electrically connected to the conductive protrusion; and the power board includes a conductive hole, the conductive protrusion is inserted into the conductive hole, and the conductive protrusion is electrically connected to the conductive hole. Through a connection between the conductive protrusion and the conductive hole, the power board and the regulation board can be fastened, and a signal connection between the power board and the regulation board can be implemented.

During specific disposing, the regulation board includes two conductive protrusions, and the two conductive protrusions are both located at an edge of a same side of the regulation board; the power board includes two conductive holes, and the two conductive holes are connected to the two conductive protrusions in a one-to-one correspondence; and the two conductive holes are distributed on two sides of the conductive wire. By disposing the two conductive holes and the two conductive protrusions, connection stability and connection strength between the regulation board and the power board can be improved. The two conductive holes are distributed on the two sides of the conductive wire, so that after the power board is inserted into the regulation board, the semi-closed Rogowski coil can cross the conductive wire, facilitating mounting.

During specific disposing, the switching component is any one of a relay, an insulated gate bipolar transistor, and a metal-oxide-semiconductor field-effect transistor.

In an example, the backup power device may further include a housing, an input port, and an output port; and both the input port and the output port penetrate the housing, so that an external power-consuming device and an external power supply device are connected to the backup power device. Both the power board and the regulation board are located in the housing, and the conductive wire is connected between the input port and the output port. An external alternating current may be transmitted from the input port to the backup power device, and then output from the output port. In the backup power device provided in embodiments of this application, a current detection function may be implemented through the foregoing power board and the regulation board, and use safety and reliability are good. In addition, the power board and the regulation board have advantages of miniaturization and low costs, so that the backup power device using the power board and the regulation board also has advantages of miniaturization and low costs, which facilitates wide application of the backup power device and good usage of the backup power device in a scenario having a high requirement on space.

In an example, the backup power device further includes a circuit breaker, the circuit breaker is connected between the conductive wire and the output port, and the circuit breaker is configured to connect or disconnect a conductive path between the conductive wire and the output port. The circuit breaker may be specifically a device having a large current connection or disconnection capability. It may be understood that, in the backup power device, the switching component usually does not have the large current connection or disconnection capability. Therefore, in the backup power device provided in this application, an additional circuit breaker is provided, so that when a working condition like a short circuit occurs in an external power-consuming device connected to the output port, a transmission path of a current may be cut off by using the circuit breaker. In this case, the switching component in the backup power device may keep in an on state.

For example, when the current in the conductive wire is greater than or equal to the preset value, the regulation circuit generates a corresponding detection signal. In this case, the detection signal does not meet the condition, and the controller cannot switch the on state or the off state of the switching component. Therefore, the controller may cut off the transmission path of the current by controlling the circuit breaker.

According to a second aspect, this application further provides a photovoltaic system, including a photovoltaic power generation device, an inverter, and the foregoing backup power device. The inverter is connected between the photovoltaic power generation device and the backup power device, and the inverter is connected to the input port. The inverter is configured to: convert a direct current generated by the photovoltaic power generation device into an alternating current, and then transmit the alternating current to the input port. The output port is configured to connect to a power grid.

### BRIEF DESCRIPTION OF DRAWINGS

FIG. 1 is a diagram of an application scenario of a power board assembly according to an embodiment of this application;
FIG. 2 is a diagram of a structure of a conventional power board assembly according to an embodiment of this application;
FIG. 3 is a diagram of a structure of a power board assembly according to an embodiment of this application;
FIG. 4 is a circuit diagram of a regulation circuit according to an embodiment of this application;
FIG. 5 is a diagram of an exploded structure of a power board assembly according to an embodiment of this application;
FIG. 6 is a diagram of a side structure of a power board assembly according to an embodiment of this application;
FIG. 7 is a diagram of a structure of a semi-closed Rogowski coil according to an embodiment of this application;
FIG. 8 is a diagram of a structure of a backup power device according to an embodiment of this application; and
FIG. 9 is a diagram of an application scenario of a backup power device according to an embodiment of this application.

### DESCRIPTION OF EMBODIMENTS

To make the objectives, technical solutions, and advantages of this application clearer, the following further describes this application in detail with reference to the accompanying drawings.

To facilitate understanding of a backup power device provided in embodiments of this application, the following first describes an application scenario of the backup power device.

The backup power device provided in embodiments of this application may be used in a plurality of devices or scenarios in which transmission of electric energy needs to be connected or disconnected.

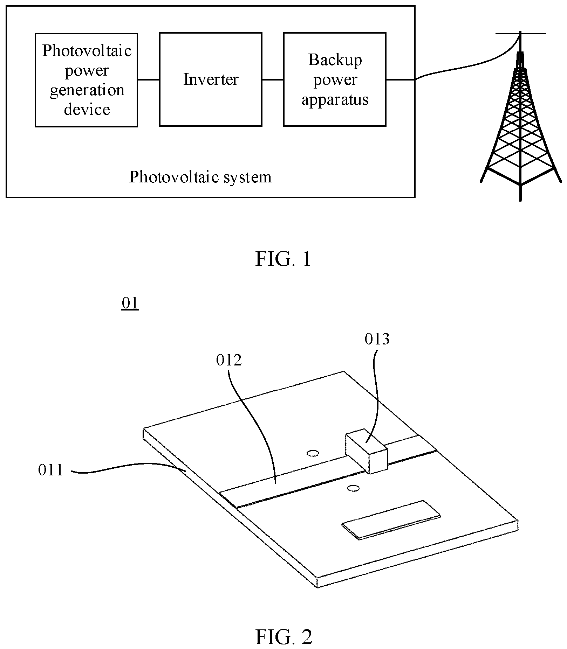

For example, as shown in FIG. 1, in an example provided in this application, the photovoltaic system may include a photovoltaic power generation device, an inverter, and a backup power device. The photovoltaic power generation device is configured to convert light energy into a direct current, and the inverter is configured to: convert the direct current generated by the photovoltaic power generation device into an alternating current and then transmit the alternating current to a power grid. The backup power device is connected between the inverter and the power grid, and is configured to implement connection or disconnection between the inverter and the power grid. In other words, the backup power device may connect a power supply path between the inverter and the power grid, so that electric energy generated by the photovoltaic power generation device can be transmitted to the power grid. Alternatively, the backup power device may disconnect the power supply path between the inverter and the power grid, so that the electric energy generated by the photovoltaic power generation device cannot be transmitted to the power grid.

As shown in FIG. 2, the backup power device includes a power board assembly 01. The power board assembly 01 may include a printed circuit board 011 (PCB), and the printed circuit board includes a conductive wire 012. The conductive wire 012 is configured to transmit an alternating current, so that the alternating current output from the inverter can be transmitted to the power grid through the conductive wire 012. In addition, a switching component like a circuit breaker 013 is further disposed on the printed circuit board. The switching component 013 is connected in series to the conductive wire 012, and is configured to connect or disconnect the conductive wire 012, to implement an on or off function of the power board assembly 01.

In an actual application, to ensure use safety of the power board assembly 01, a current flowing through the conductive wire 012 needs to be effectively detected, to ensure use safety of the power board assembly 01.

In the existing power board assembly 01, two solutions are usually used to effectively detect the current in the conductive wire 012. One solution is to use a sampling resistance, and the other solution is to use a current transformer (CT). Simply speaking, in the sampling resistor solution, a sampling resistor, and components like an amplifier matching the sampling resistor, an isolation operational amplifier, and a comparator may be disposed on the printed circuit board 011. In the sampling resistor solution, a large quantity of components are used, occupying a large board area. In addition, the isolation operational amplifier needs to be powered by three independent isolated power supplies. In summary, the sampling resistor solution has high costs and occupies a large board area, which is not conducive to wide application. For the current transformer solution, the current transformer needs to be installed in the outside, occupying large space and requiring a complex signal cable connection. In addition, the current transformer has high costs, and therefore is not conducive to wide application.

Therefore, embodiments of this application provide a cost-effective power board assembly that has a good current detection function and occupies a small board area, and a backup power device equipped with the power board assembly.

To make the objectives, technical solutions, and advantages of this application clearer, the following further describes this application in detail with reference to the accompanying drawings and specific embodiments.

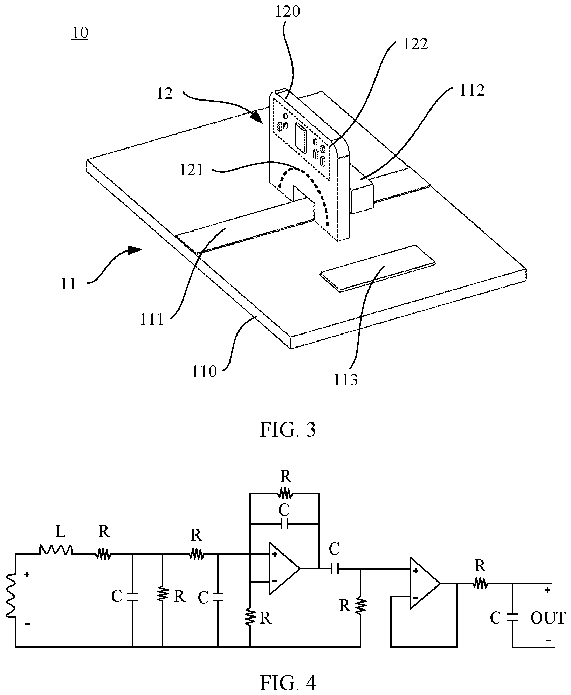

As shown in FIG. 3, in an example provided in this application, the power board assembly 10 includes a power board 11 and a regulation board 12. The regulation board 12 is disposed on a surface of the power board 11, and the regulation board 12 is perpendicular to the power board 11. The power board 11 includes a conductive wire 111 and a switching component 112. The switching component 112 is connected to the conductive wire 111 in series, and is configured to connect or disconnect the conductive wire 111. The regulation board 12 includes a semi-closed Rogowski coil 121 and a regulation circuit 122, and the regulation circuit 122 is connected to the semi-closed Rogowski coil 121. The semi-closed Rogowski coil 121 crosses the conductive wire 111, and the semi-closed Rogowski coil 121 is configured to: induce a current in the conductive wire 111 and generate an induction signal, to effectively detect the current in the conductive wire 111. The regulation circuit 122 is configured to generate a detection signal after performing operation processing on the induction signal. The power board assembly 10 further includes a controller 113. The controller 113 is disposed on the power board 11. The controller 113 is connected to the regulation circuit 122 and the switching component 112. The controller 113 is configured to control on or off of the switching component 112 based on the detection signal of the regulation circuit 122, to implement a function like current short-circuit protection.

Specifically, in the example provided in this application, the regulation board 12 is perpendicularly disposed on a surface of the power board 11, so that a board area occupied by the regulation board 12 on the power board 11 can be effectively reduced. This helps implement a miniaturization design of the power board 11. In addition, more other electronic components can be disposed on the power board 11, to improve functions of the power board 11. After the semi-closed Rogowski coil 121 is used in the regulation board 12, the regulation board 12 can be disposed on the surface of the power board 11 in a form of single-side layout, and a good current detection function can be implemented. After the regulation board 12 is disposed on the surface of the power board 11, the semi-closed Rogowski coil 121 crosses the conductive wire 111 in the power board 11. When an alternating current flows through the conductive wire 111, the semi-closed Rogowski coil 121 may generate the corresponding induction signal according to an electromagnetic induction principle. The regulation circuit 122 generates the corresponding detection signal after performing operation processing on the induction signal. The controller 113 may control on or off of the switching component 112 based on the detection signal, to ensure use safety of the power board 11.

In summary, in the example provided in this application, the semi-closed Rogowski coil 121 has an advantage of low costs, which is conducive to wide application. The semi-closed Rogowski coil 121 is used, so that the regulation board 12 can be perpendicularly disposed on a side of the power board 11, and a good current detection function is implemented. In addition, the regulation board 12 occupies a small board area in the power board 11, which helps implement a miniaturization design of the power board assembly 10, so that the power board assembly 10 can be better used in a device having a high requirement on space. The regulation board 12 being perpendicular to the power board 11 means that the regulation board 12 is approximately perpendicular to the power board 11, that is, an included angle between the regulation board 12 and the power board 11 may be about 90 degrees, which is not perpendicular in a strict sense.

The controller 113 being configured to control on or off of the switching component 112 based on the detection signal of the regulation circuit 122 specifically means that the controller 113 further needs to refer to the detection signal when switching an on state or an off state of the switching component 112 based on the control signal. Alternatively, it may be understood that, when the detection signal meets a condition, the controller 113 may switch the on state or the off state of the switching component 112. When the detection signal does not meet the condition, the controller 113 cannot switch the on state or the off state of the switching component 112.

For example, when a current in the conductive wire 111 is less than a preset value, the regulation circuit 122 generates a corresponding detection signal. In this case, the detection signal meets the condition, and the controller 113 may switch the on state or the off state of the switching component 112.

Alternatively, when the current in the conductive wire 111 is greater than or equal to the preset value, the regulation circuit 122 generates a corresponding detection signal. In this case, the detection signal does not meet the condition, and the controller 113 cannot switch the on state or the off state of the switching component 112.

Alternatively, it may be understood that, in some cases, the switching component 112 does not have a turn-on/off capability under a large current; otherwise, a bad case like arcing may occur. Therefore, the switching component 112 is allowed to switch between the on state and the off state only when the current in the conductive wire 111 is small, so that use safety of the switching component 112 can be ensured.

It should be noted that a Rogowski coil is usually a hollow ring coil, and may be directly sleeved on the measured conductive wire 111. An alternating current flowing through the conductive wire 111 generates an alternating magnetic field around the conductive wire 111, so that an alternating-current voltage signal that is proportional to a current change ratio is induced in the Rogowski coil. An alternating-current voltage signal is obtained after the voltage signal output by the Rogowski coil is integrated by using an integrator or an integral circuit. The alternating-current voltage signal can accurately reproduce a waveform of a measured current signal.

A working principle of the semi-closed Rogowski coil 121 is basically the same as that of the conventional Rogowski coil. In the example provided in this application, the semi-closed Rogowski coil 121 may be considered as a structural variation of the Rogowski coil. That is, the Rogowski coil is in an approximately closed ring shape, and the semi-closed Rogowski coil 121 is in an approximately U or semi-ring shape. The semi-closed Rogowski coil 121 is configured to: induce a current in the conductive wire 111 and generate an induction signal. The induction signal is a voltage signal. The regulation circuit 122 is configured to generate a detection signal after performing operation processing on the induction signal (namely, the voltage signal).

In the example provided in this application, the regulation circuit 122 includes an integrator and an amplifier. The integrator is configured to perform integration on the induction signal (namely, the voltage signal) generated by the semi-closed Rogowski coil 121 to obtain an alternating current voltage signal, and the amplifier amplifies the alternating current voltage signal and outputs the amplified alternating current voltage signal. That is, the detection signal generated by the foregoing regulation circuit 122 is the alternating current voltage signal processed by the integrator and the amplifier. The controller 113 controls, based on the alternating current voltage signal, the switching component 112 to be disconnected or connected.

During actual application, there may be various specific types of the regulation circuit 122. For example, as shown in FIG. 4, an embodiment of this application provides a circuit diagram of the regulation circuit 122. A left end of the regulation circuit 122 is used as an input end, and is configured to connect to the semi-closed Rogowski coil 121 to receive the induction signal of the semi-closed Rogowski coil 121. A right end of the regulation circuit 122 is used as an output end, and is configured to connect to the controller 113 to output the detection signal.

It should be noted that, during specific setting, the regulation circuit 122 may use a currently commonly used type and circuit structure. This is not limited in this application.

In the example provided above, the controller 113 is disposed on the surface of the power board 11. In another example, the controller 113 may alternatively be disposed on a surface of the regulation board 12. A disposing position of the controller 113 is not specifically limited in this application.

As shown in FIG. 3, during specific application, the power board 11 may specifically include a printed circuit board. For example, the power board 11 includes a dielectric substrate 110, and a copper layer is provided on a surface of the dielectric substrate 110. The copper layer may form the conductive wire 111. Electronic components such as the controller 113 and the switching component 112 may be disposed on a surface of the dielectric substrate 110 and connected to the conductive wire 111 (not shown in the figure) in the dielectric substrate 110 through a surface-mount technology or the like. During actual application, parameters such as a width, a thickness, and a form of the conductive wire 111 may be appropriately set based on an actual requirement. Details are not described herein.

In addition, the regulation board 12 may also specifically include a printed circuit board. For example, the regulation board 12 includes a dielectric substrate 120, and components such as an inductor and a capacitor in the regulation circuit 122 may be disposed on a surface of the dielectric substrate 120 and connected to a conductive wire 111 (not shown in the figure) in the dielectric substrate 120 through a surface-mount technology or the like.

The power board 11 and the regulation board 12 may alternatively be disposed in various manners.

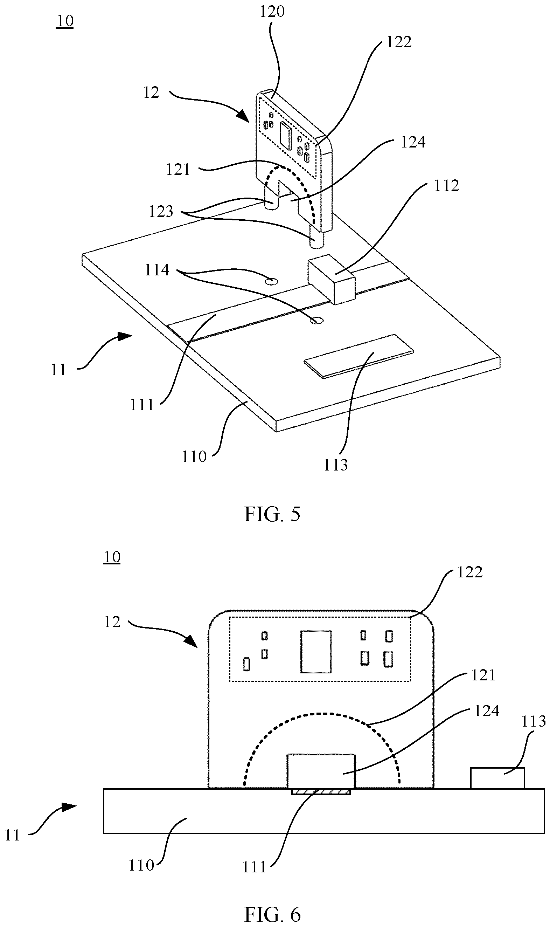

For example, as shown in FIG. 5, in an example provided in this application, an edge of the regulation board 12 includes two conductive protrusions 123, and the regulation circuit 122 is electrically connected to the conductive protrusions 123. The power board 11 includes two conductive holes 114, and the two conductive protrusions 123 are respectively inserted into the two conductive holes 114, to implement conductive connections between the conductive protrusions 123 and the conductive holes 114. In summary, a signal transmission function may be implemented between the regulation board 12 and the power board 11 through conductive connections between the conductive holes 114 and the conductive protrusions 123. The detection signal generated by the regulation circuit 122 in the regulation board 12 may be transmitted to the controller 113 in the power board 11 through conductive paths between the conductive holes 114 and the conductive protrusions 123. That is, in this application, through insertion connections between the conductive protrusions 123 and the conductive holes 114, fastening between the regulation board 12 and the power board 11 can be implemented, and a signal connection between the regulation circuit 122 and the controller 113 can be further implemented.

In addition, in the example provided in this application, the regulation board 12 includes the two conductive protrusions 123, and both the two conductive protrusions 123 are located at an edge of a same side of the regulation board 12. The power board 11 includes the two conductive holes 114. After the two conductive protrusions 123 are inserted into the two conductive holes 114, relative rotation between the regulation board 12 and the power board 11 can be effectively prevented, thereby effectively improving connection stability and connection strength between the regulation board 12 and the power board 11.

As shown in FIG. 5, the two conductive holes 114 are located on two sides of the conductive wire 111. After the two conductive protrusions 123 are inserted into the two conductive holes 114, the two conductive protrusions 123 are also located on the two sides of the conductive wire 111, and the semi-closed Rogowski coil 121 crosses the conductive wire 111.

During specific setting, the semi-closed Rogowski coil 121 may be in an approximately semi-circular ring shape. After the regulation board 12 is inserted into the power board 11, the conductive wire 111 may be approximately located in a center of the semi-closed Rogowski coil 121, thereby ensuring detection effect of the semi-closed Rogowski coil 121. The two conductive holes 114 may be symmetrically disposed with respect to the conductive wire 111, and the two conductive protrusions 123 may be respectively located at two ends of the semi-closed Rogowski coil 121, so that after the regulation board 12 is inserted into the power board 11, the conductive wire 111 can be located at the center of the semi-closed Rogowski coil 121.

In addition, as shown in FIG. 6, in the example provided in this application, the regulation board 12 further has a notch 124, and the notch 124 directly faces the conductive wire 111. After the regulation board 12 is mounted on the power board 11, the notch 124 is located right above the conductive wire 111. Disposing the notch 124 can reduce a weight of the regulation board 12, and help implement heat dissipation of the conductive wire 111. Specifically, the notch 124 is disposed, so that a channel for air circulation may be formed between the conductive wire 111 and the regulation board 12, and when air flows through the notch 124, heat generated by the conductive wire 111 may be taken away, thereby ensuring heat dissipation performance of the conductive wire 111.

During specific setting, a form and a size of the notch 124 may be appropriately set based on an actual requirement. This is not limited in this application.

It may be understood that, during actual application, the conductive protrusion 123 may be specifically a tin connector. After the conductive protrusion 123 is inserted into the conductive hole 114, a reliable connection between the conductive protrusion 123 and the conductive hole 114 may be implemented in a soldering manner. In addition, the conductive hole 114 may be specifically a plated hole, or may be a structure like a through hole or a blind hole with a conductive material on an inner wall. During specific disposing, specific structures and forms of the conductive hole 114 and the conductive protrusion 123 may be flexibly adjusted based on an actual requirement. This is not limited in this application.

In another example, the regulation board 12 may alternatively include one conductive protrusion 123, and the power board 11 may alternatively include one conductive hole 114. A signal connection function between the regulation board 12 and the power board 11 may be implemented through an insertion connection between the conductive hole 114 and the conductive protrusion 123.

Alternatively, in some examples, the regulation board 12 may alternatively include two protrusions, and the power board 11 may alternatively include two through holes. One of the protrusions may be a protrusion having a conductive function, and the other protrusion may not have the conductive function. Correspondingly, one through hole may be a through hole having a conductive function, and the other through hole may not have the conductive function. That is, after the protrusion with the conductive function is inserted into the through hole with the conductive function, a mechanical connection and a conductive connection between the power board 11 and the regulation board 12 may be implemented. After the protrusion without the conductive function is inserted into the through hole without the conductive function, the mechanical connection between the power board 11 and the regulation board 12 may be implemented.

In another example, the regulation board 12 may alternatively include three or more protrusions, and the power board 11 may alternatively include three or more through holes. During actual application, quantities and location layouts of the protrusions and the through holes may be appropriately set based on an actual requirement. Details are not described herein.

When the semi-closed Rogowski coil 121 is disposed, the semi-closed Rogowski coil 121 may also be disposed in various manners.

For example, as shown in FIG. 6, in an example provided in this application, the semi-closed Rogowski coil 121 is located in the dielectric substrate, so that the dielectric substrate can effectively protect the semi-closed Rogowski coil 121, and prevent an external force from directly acting on the semi-closed Rogowski coil 121. Therefore, the semi-closed coil can be effectively protected, and security and reliability of the semi-closed Rogowski coil 121 can be provided.

Alternatively, in another example, the semi-closed Rogowski coil 121 may alternatively be disposed on a side of the dielectric substrate. Alternatively, it may be understood that, the semi-closed Rogowski coil 121 may be disposed on the surface of the dielectric substrate, effectively facilitating preparation of the semi-closed Rogowski coil 121.

Alternatively, in some examples, after the semi-closed Rogowski coil 121 is disposed on a side of the dielectric substrate, the semi-closed Rogowski coil 121 may be further packaged through a packaging process, so that a packaging material like resin effectively wraps the semi-closed Rogowski coil 121, thereby improving security and reliability of the semi-closed Rogowski coil 121.

During specific disposing, a disposing manner of the semi-closed Rogowski coil 121 may be properly selected and adjusted based on an actual requirement. Details are not described herein.

In addition, as shown in FIG. 6, in an example provided in this application, the semi-closed Rogowski coil 121 is located between the regulation circuit 122 and the conductive wire 111. In other words, the regulation circuit 122 is located on a side that is of the semi-closed Rogowski coil 121 and that is away from the conductive wire 111, so that the regulation circuit 122 does not cause interference to normal operation of the semi-closed Rogowski coil 121. In addition, the semi-closed Rogowski coil 121 is located between the regulation circuit 122 and the conductive wire 111, so that the semi-closed Rogowski coil 121 can form an effective electromagnetic shielding effect, and can prevent an alternating magnetic field generated near the conductive wire 111 from interfering with the regulation circuit 122.

It may be understood that, during specific setting, relative positions of the regulation circuit 122 and the semi-closed Rogowski coil 121 may be appropriately set based on an actual requirement, to ensure stable operation of the regulation circuit 122 and the semi-closed Rogowski coil 121. Details are not described herein.

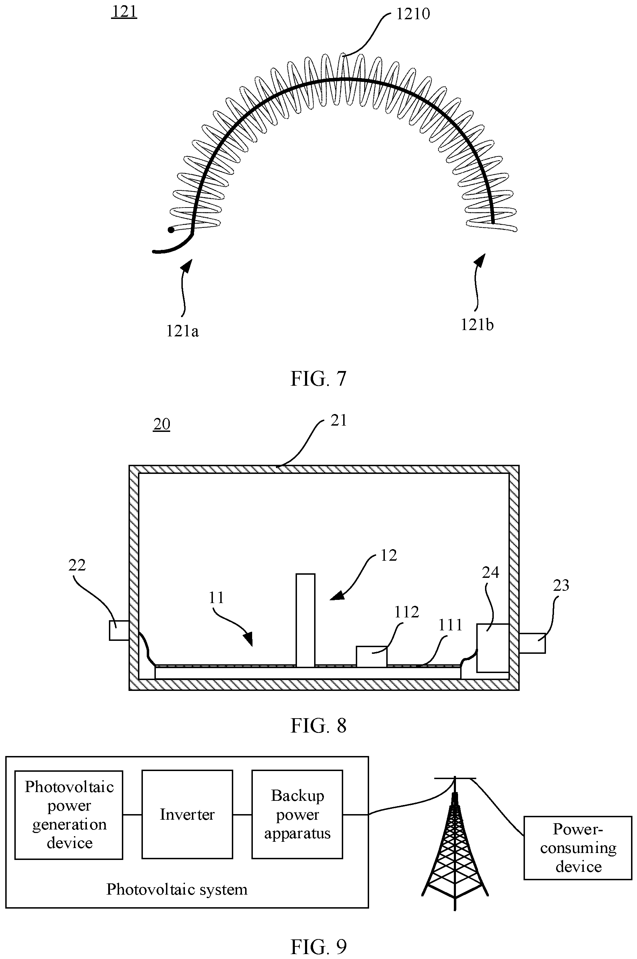

In addition, as shown in FIG. 7, in the example provided in this application, both output ends of the semi-closed Rogowski coil 121 are located on a same side of the semi-closed Rogowski coil 121, to connect to the regulation circuit 122.

Specifically, the semi-closed Rogowski coil 121 includes a first end 121a (for example, a left end in FIG. 7) and a second end 121b (for example, a right end in FIG. 7). The semi-closed Rogowski coil 121 includes a spiral wire 1210. Both ends of the spiral wire 1210 are used as output ends and are located at the first end 121a.

In the example provided in this application, in the semi-closed Rogowski coil 121, one end of the spiral wire 1210 is located at the first end 121a, and the other end of the spiral wire 1210 extends from the second end 121b along an axis of the semi-closed Rogowski coil 121 to the first end 121a. It should be noted that the axis of the semi-closed Rogowski coil 121 is a virtual axis of the semi-closed Rogowski coil 121. In the example provided in this application, the semi-closed Rogowski coil 121 is in an approximately U form as a whole, in other words, the axis of the semi-closed Rogowski coil 121 is in an approximately U form. In other words, when the semi-closed Rogowski coil 121 is prepared, the spiral wire 1210 is wound along the axis. After the winding is completed, one end of the spiral wire 1210 extends in a path of the axis to the other end, so that the two ends of the spiral wire 1210 are located at the same end of the entire semi-closed Rogowski coil 121. In this disposing manner, internal space of the semi-closed Rogowski coil 121 can be appropriately used, and the semi-closed Rogowski coil 121 can be easily connected to the regulation circuit 122.

It may be understood that, during actual application, a parameter of the semi-closed Rogowski coil 121 may be appropriately set based on an actual requirement. This is not limited in this application. The parameter of the semi-closed Rogowski coil 121 includes but is not limited to a form, a quantity of circles, a diameter of the spiral wire, and the like of the semi-closed Rogowski coil 121.

In addition, in the foregoing example, the switching component 112 may be specifically any one of a relay, an insulated gate bipolar transistor, or a metal-oxide-semiconductor field-effect transistor. A specific type of the switching component 112 is not limited in this application.

During actual application, the power board assembly 10 may be used in a plurality of devices or scenarios in which a current connection and disconnection is implemented.

For example, as shown in FIG. 8, an embodiment of this application further provides a backup power device 20. The backup power device 20 may also be referred to as a backup power box, a backup power case, or the like. The backup power device 20 may include a housing 21, an input port 22, an output port 23, and the foregoing power board assembly 10. Both the input port 22 and the output port 23 penetrate the housing 21, to implement connection between the backup power device 20 and another external power supply device or an external power-consuming device. The power board assembly 10 is located in the housing 21, and the conductive wire 111 is connected between the input port 22 and the output port 23. An external alternating current may be transmitted from the input port 22 to the backup power device 20, and then output from the output port 23. In the backup power device 20 provided in embodiments of this application, a current detection function may be implemented through the foregoing power board assembly 10, and use safety and reliability are good. In addition, the power board assembly 10 has advantages of miniaturization and low costs, so that the backup power device 20 using the power board assembly 10 also has advantages of miniaturization and low costs, which facilitates wide application of the backup power device 20, and the backup power device 20 can be well used in a scenario having a high requirement on space.

In addition, as shown in FIG. 8, in an example provided in this application, the backup power device 20 may further include a circuit breaker 24. The circuit breaker 24 is connected between the conductive wire 111 and the output port of the power board 11, and is configured to connect or disconnect a conductive path between the conductive wire 111 and the output port. The circuit breaker 24 may be specifically a device having a large current connection or disconnection capability, for example, an air switch. It may be understood that, in the power board assembly 10, to ensure safety of the power board assembly 10, the switching component 112 usually does not have a capability of connecting and disconnecting a large current. Therefore, in the example provided in this application, an additional circuit breaker 24 is disposed in the backup power device 20, so that when a working condition like a short circuit occurs on an external power-consuming device connected to the output port 23, a transmission path of a current may be cut off by using the circuit breaker 24. In this case, the switching component 112 in the power board assembly 10 may keep in an on state.

For example, when a current in the conductive wire 111 is greater than or equal to a preset value, the regulation circuit generates a corresponding detection signal. In this case, the controller 113 cannot switch the on state or an off state of the switching component 112. Therefore, the controller 113 may cut off the transmission path of the current by controlling the circuit breaker 24.

During actual application, the backup power device 20 may be used in a plurality of scenarios.

For example, as shown in FIG. 9, an embodiment of this application further provides a photovoltaic system, including a photovoltaic power generation device, an inverter, and a backup power device. The photovoltaic power generation device is configured to convert light energy into a direct current, and the inverter is configured to: convert the direct current generated by the photovoltaic power generation device into an alternating current and then transmit the alternating current to a power grid. The backup power device is connected between the inverter and the power grid, and is configured to implement connection or disconnection between the inverter and the power grid. In other words, the backup power device may connect a power supply path between the inverter and the power grid, so that electric energy generated by the photovoltaic power generation device can be transmitted to the power grid. Alternatively, the backup power device may disconnect the power supply path between the inverter and the power grid, so that the electric energy generated by the photovoltaic power generation device cannot be transmitted to the power grid.

A power-consuming device like a home load may be connected to the power grid, to ensure normal use of the power-consuming device. During actual use, a working condition like a short circuit may occur in the power-consuming device, resulting in a large current in a conductive wire 111 in the backup power device. In this case, a circuit breaker of the power-consuming device may be used to cut off a transmission path of the current. Alternatively, the current transmission path between the backup power device and the power grid may be cut off by using a circuit breaker in the backup power device.

It may be understood that, during actual application, when a working condition like a short circuit occurs in the power-consuming device, a on or off state of the circuit breaker in the backup power device may be flexibly switched based on an actual requirement. This is not limited in this application.

In various embodiments of this application, unless otherwise stated or there is a logic conflict, terms and/or descriptions in different embodiments are consistent and may be mutually referenced, and technical features in different embodiments may be combined based on an internal logical relationship thereof, to form a new embodiment.

"A plurality of" in this application refers to two or more than two. "And/or" describes an association relationship between associated objects and indicates that three relationships may exist. For example, A and/or B may indicate the following three cases: Only A exists, both A and B exist, and only B exists, where A and B may be singular or plural.

It may be understood that various numbers in embodiments of this application are merely used for differentiation for ease of description, and are not used to limit the scope of embodiments of this application. Sequence numbers of the foregoing processes do not mean an execution sequence, and the execution sequence of the processes should be determined based on functions and internal logic of the processes.

## Claims

1. A backup power device, comprising a power board and a regulation board, wherein the regulation board is disposed on a surface of the power board, and the regulation board is perpendicular to the power board;
the power board comprises a conductive wire and a switching component, and the switching component is connected to the conductive wire in series;
the regulation board comprises a semi-closed Rogowski coil and a regulation circuit, and the regulation circuit is connected to the semi-closed Rogowski coil;
the semi-closed Rogowski coil crosses the conductive wire, and is configured to: induce a current in the conductive wire and generate an induction signal, and the regulation circuit is configured to generate a detection signal after performing operation processing on the induction signal; and
the backup power device further comprises a controller, and the controller is configured to control on or off of the switching component based on the detection signal of the regulation circuit.

2. The backup power device according to claim 1, wherein the controller is configured to: when the current in the conductive wire is less than a preset value, control on or off of the switching component.

3. The backup power device according to claim 1 or 2, wherein the controller is configured to: when the current in the conductive wire is greater than or equal to the preset value, control the switching component to remain on or off.

4. The backup power device according to any one of claims 1 to 3, wherein the semi-closed Rogowski coil is in a semi-circular ring shape, and the conductive wire penetrates a center of the semi-closed Rogowski coil.

5. The backup power device according to any one of claims 1 to 4, wherein the regulation board comprises a dielectric substrate, and the semi-closed Rogowski coil is located in the dielectric substrate.

6. The backup power device according to any one of claims 1 to 4, wherein the regulation board comprises a dielectric substrate, and the semi-closed Rogowski coil is located on a side of the dielectric substrate.

7. The backup power device according to any one of claims 1 to 6, wherein the semi-closed Rogowski coil is located between the regulation circuit and the conductive wire.

8. The backup power device according to any one of claims 1 to 7, wherein the semi-closed Rogowski coil comprises a first end and a second end; and
the semi-closed Rogowski coil is formed by a spiral wire, and both ends of the spiral wire are located at the first end or the second end.

9. The backup power device according to claim 8, wherein in the semi-closed Rogowski coil, one end of the spiral wire is located at the first end, and the other end of the spiral wire penetrates the second end along an axis of the semi-closed Rogowski coil to the first end; or one end of the spiral wire is located at the second end, and the other end of the spiral wire penetrates the first end along an axis of the semi-closed Rogowski coil to the second end.

10. The backup power device according to any one of claims 1 to 9, wherein an edge of the regulation board comprises a conductive protrusion, and the regulation circuit is electrically connected to the conductive protrusion; and
the power board comprises a conductive hole, the conductive protrusion is inserted into the conductive hole, and the conductive protrusion is electrically connected to the conductive hole.

11. The backup power device according to claim 10, wherein the regulation board comprises two conductive protrusions, and the two conductive protrusions are both located at an edge of a same side of the regulation board;
the power board comprises two conductive holes, and the two conductive holes are connected to the two conductive protrusions in a one-to-one correspondence; and
the two conductive holes are distributed on two sides of the conductive wire.

12. The backup power device according to any one of claims 1 to 11, wherein the switching component is any one of a relay, an insulated gate bipolar transistor, and a metal-oxide-semiconductor field-effect transistor.

13. The backup power device according to any one of claims 1 to 12, wherein the backup power device further comprises a housing, an input port, and an output port; and
both the input port and the output port penetrate the housing, both the power board and the regulation board are located in the housing, and the conductive wire is connected between the input port and the output port.

14. The backup power device according to any one of claims 1 to 13, wherein the backup power device further comprises a circuit breaker, the circuit breaker is connected between the conductive wire and the output port, and the circuit breaker is configured to connect or disconnect a conductive path between the conductive wire and the output port.

15. A photovoltaic system, comprising a photovoltaic power generation device, an inverter, and the backup power device according to any one of claims 1 to 14, wherein
the inverter is connected between the photovoltaic power generation device and the backup power device, and the inverter is connected to the input port; and
the inverter is configured to: convert a direct current generated by the photovoltaic power generation device into an alternating current, and then transmit the alternating current to the input port, wherein the output port is configured to connect to a power grid.
